(19) Europäisches Patentamt / European Patent Office / Office européen des brevets

(11) **EP 4 207 605 B1**

(12) **FASCICULE DE BREVET EUROPEEN**

(45) Date de publication et mention
de la délivrance du brevet:
**04.02.2026 Bulletin 2026/06**

(21) Numéro de dépôt: **22217027.6**

(22) Date de dépôt: **28.12.2022**

(51) Classification Internationale des Brevets (IPC):
***H03M 7/30*** (2006.01)   ***H04L 27/00*** (2006.01)

(52) Classification Coopérative des Brevets (CPC):
**H03M 7/3062; H04L 27/0004**

(54) **MÉTHODE D ACQUISITION COMPRIMÉE ET DE RECONSTRUCTION D'UN SIGNAL SPECTRALEMENT PARCIMONIEUX**

VERFAHREN ZUR KOMPRIMIERTEN ERFASSUNG UND REKONSTRUKTION EINES SPEKTRAL ABGETASTETEN SIGNALS

METHOD FOR COMPRESSED SENSING AND RECONSTRUCTION OF A SPECTRALLY SPARSE SIGNAL

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité:   **29.12.2021   FR 2114628**

(43) Date de publication de la demande:
**05.07.2023   Bulletin 2023/27**

(73) Titulaire: **Commissariat à l'Energie Atomique et aux Energies Alternatives**
**75015 Paris (FR)**

(72) Inventeurs:
• **ZARUDNIEV, Mykhailo**
**38054 GRENOBLE CEDEX 09 (FR)**
• **PELISSIER, Michael**
**38054 GRENOBLE CEDEX 09 (FR)**
• **GULFO MONSALVE, Jorge-Luis**
**38054 GRENOBLE CEDEX 09 (FR)**

(74) Mandataire: **Santarelli**
**Tour Trinity**
**1 bis Place de la Défense**
**92400 Courbevoie (FR)**

(56) Documents cités:
**EP-A1- 3 319 236       EP-A1- 3 681 040**
**US-A1- 2015 003 738     US-B2- 10 066 997**

• **DE VITO LUCA ET AL: "Non-Uniform Wavelet Bandpass Sampling Analog-to-Information Converter: A hardware implementation and its experimental assessment", MEASUREMENT., vol. 134, 1 February 2019 (2019-02-01), GB, pages 739 - 749, XP055943528, ISSN: 0263-2241, DOI: 10.1016/j.measurement.2018.11.015**

**Description**

**Domaine technique**

La présente invention concerne de manière générale le domaine de l'acquisition comprimée (*compressed sensing*) et de la détection de spectre (*spectral sensing*). Elle s'applique notamment à la détection et la localisation fréquentielle dans les signaux Wi-Fi.

**Etat de la technique antérieure**

L'acquisition compressée d'un signal repose sur le fondement théorique suivant : un signal spectralement parcimonieux dans une bande spectrale donnée, c'est-à-dire dont l'information n'est pas contenue dans l'intégralité de la bande en question mais seulement dans une ou plusieurs de ses sous-bandes, peut être échantillonné sans perte à condition que sa fréquence d'échantillonnage soit proche de la fréquence de Landau, c'est-à-dire de sa largeur de bande d'information effective. Pour un signal spectralement parcimonieux, la fréquence de Landau peut être sensiblement inférieure à la fréquence de Nyquist.

Lorsque le signal à acquérir est un signal RF multi-bande, autrement dit lorsqu'il occupe certaines sous-bandes d'une bande spectrale donnée, il est connu de recourir à un sous-échantillonnage passe-bande (dit encore échantillonnage de bande passante) non uniforme par ondelettes ou NUWBS (*Non Uniform* Wavelet *Bandpass Sampling*). Celle-ci utilise un dictionnaire de fonctions élémentaires formant une base, voire simplement une famille génératrice (*overcomplete*) de $L^2(\mathbb{R})$, dénommées ondelettes. On trouvera une description détaillée de la méthode d'acquisition NUWBS dans l'article de M. Pelissier et al. Intitulé « Non-uniform wavelet sampling for RF analog-to-information conversion », publié dans IEEE Trans. On Circuits and Systems, I, Regular Papers, 2018, 65(2), pp. 471-484 ainsi que dans la demande EP-A-3 319 236, et la demande EP 3 681 040 A1.

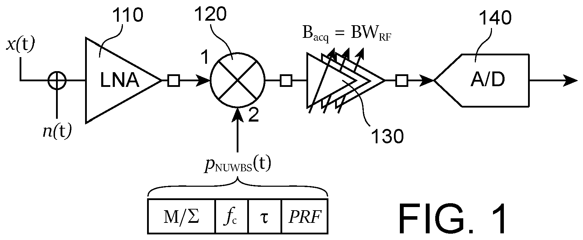

La méthode d'acquisition NUWBS est brièvement rappelée ci-après dans le contexte d'un récepteur RF représenté en Fig. 1. Le signal RF reçu à acquérir, *x(t),* bruité par un bruit blanc additif gaussien, *n*(*t*), peut occuper une ou plusieurs sous-bandes (ou canaux) d'une bande de fréquence d'acquisition de largeur $BW_{RF}$, centrée sur une fréquence porteuse, $f_c$. Le signal reçu est d'abord amplifié dans un amplificateur bas bruit (LNA), 110, puis mélangé au moyen d'un multiplieur 120, à un train d'impulsions (par exemple des ondelettes de Morlet), $p_{NUWBS}$(*t*). Le résultat du mélange est ensuite filtré et amplifié par un amplificateur à contrôle automatique de gain, 130, avant d'être échantillonné aux instants où sont présents les différentes impulsions et converti par un convertisseur analogique numérique, 140. En pratique, la multiplication est réalisée sur des valeurs complexes et l'amplification ainsi que la conversion A/D sont effectuées pour chaque voie I et Q.

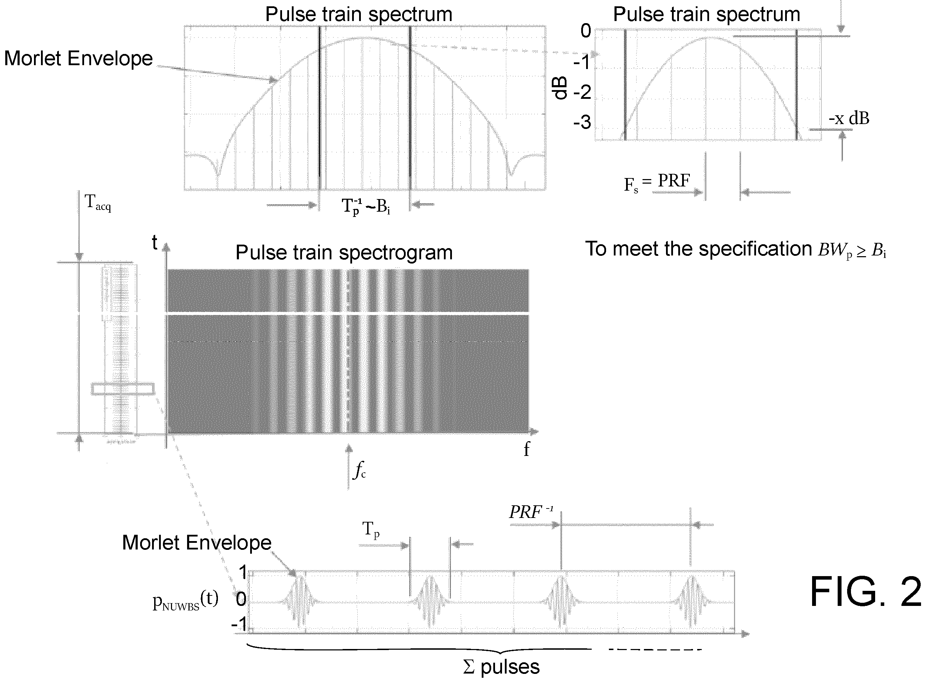

La Fig. 2 représente, dans sa partie inférieure, un exemple de train d'impulsions, $p_{NUWBS}$(*t*). Le train d'impulsions possède une durée totale $T_{acq}$, les impulsions se répétant avec une fréquence de répétition maximale *PRF,* ou, de manière équivalente tous les intervalles $\frac{1}{PRF}$. De manière générale, un train d'impulsions comprend au plus $\Sigma$ positions temporelles possibles équidistribuées sur la durée d'acquisition $T_{acq}$, dont M ≤ $\Sigma$ sont effectivement occupées par des impulsions les autres positions étant inoccupées. Le rapport $M/\Sigma$, également dénommé taux de compression, définit le taux d'occupation du train d'impulsions sur la durée d'acquisition, $T_{acq}$. La durée $\tau$ d'une impulsion est choisie de manière à être de l'ordre de l'inverse de la largeur de bande, $BW_{RF}$, du signal à acquérir. La largeur de bande $BW_{RF}$ est déterminée à partir d'une valeur d'atténuation prédéterminée en dB, généralement -3dB. En outre, la fréquence porteuse de l'impulsion est choisie sensiblement égale à la fréquence $f_c$.

Le spectre d'un train d'impulsions est représenté dans la partie supérieure de la Fig. 2. Celui-ci est un spectre de raies espacées de la fréquence de répétition *PRF,* centré sur la fréquence porteuse, $f_c$ et modulé par la forme spectrale de l'enveloppe d'une impulsion.

La partie centrale de la figure, représente un spectrogramme d'un train d'impulsions, c'est-à-dire une analyse temps-fréquence correspondant la transformée de Fourier d'un train d'impulsions se répétant périodiquement avec la période $T_{acq}$. On remarque que le spectrogramme présente des raies sensiblement alignées avec celles du spectre audessus et reste constant dans le temps.

Revenant à la Fig. 1, le train d'impulsions, $p_{NUWBS}$(*t*), mélangé avec le signal reçu, est caractérisé par son taux de compression, $M/\Sigma$, la fréquence porteuse, $f_c$, et la durée, $\tau$, de ses impulsions, ainsi que la fréquence de répétition maximale, $PRF = \frac{\Sigma}{T_{acq}}$. La fréquence de répétition moyenne des impulsions n'est alors autre que $(M/\Sigma)PRF$.

L'échantillonnage NUWBS est non-uniforme en raison de la distribution aléatoire de M impulsions parmi les $\Sigma$ positions temporelles possibles au sein de la trame d'acquisition. Pour un taux de compression donné, les impulsions sont sélectionnées au moyen d'un tirage pseudo-aléatoire par une séquence PRBS *(Pseudo-Random Binary Sequence).*

Le taux de compression $M/\Sigma$ détermine, d'une part, le degré maximal de parcimonie spectrale que peut atteindre le récepteur et, d'autre part, la cadence moyenne à laquelle doit opérer le convertisseur analogique-numérique.

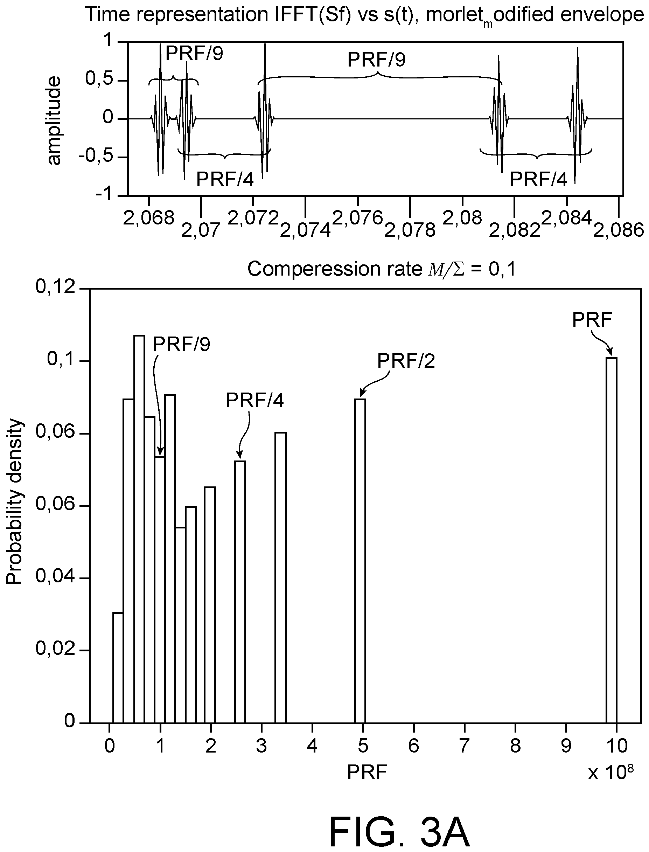

La Fig. 3A représente un histogramme de la fréquence de répétition des impulsions, autrement dit la densité de probabilité de la fréquence de répétition des impulsions pour un taux de compression de $M/\Sigma = 0.1$. On remarque que cette fréquence de répétition prend des valeurs fractionnaires de la fréquence de répétition maximale, $PRF$ : $PRF/2$, $PRF/3$, $PRF/4$, etc.

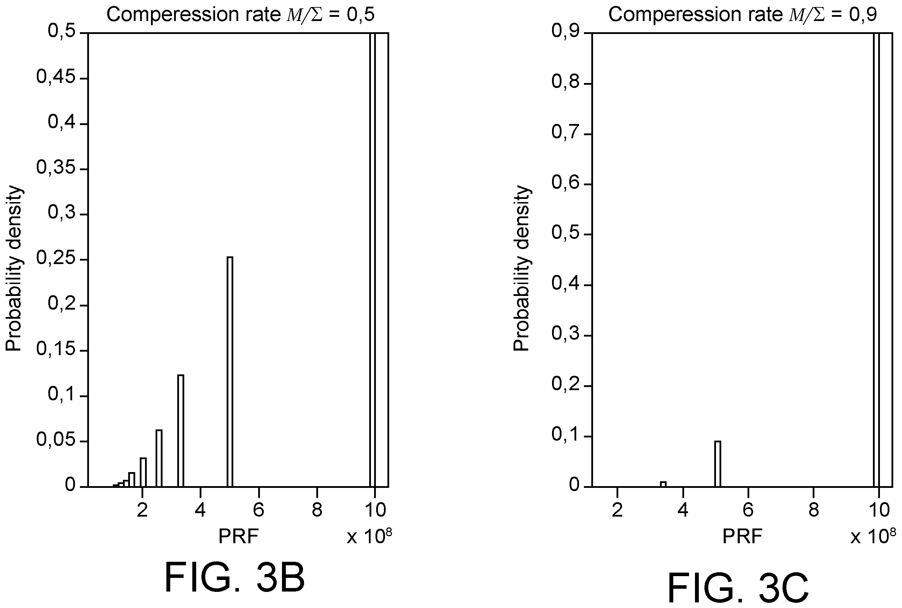

Les Figs. 3B et 3C représentent la densité de fréquence de répétition des impulsions, respectivement pour un taux de compression $M/\Sigma = 0.5$ et $M/\Sigma = 0.9$. On remarque que lorsque le taux de compression augmente, la distribution de densité de probabilité de la fréquence de répétition tend à se concentrer sur la valeur maximale, $PRF$. Cette concentration est problématique dans la mesure où la cadence de conversion du convertisseur analogique/digital doit suivre la fréquence de répétition maximale du train d'impulsions, celle-ci devant par ailleurs être égale à la largeur de bande $BW_{RF}$ si l'intégralité de la bande est à analyser ou à acquérir. En d'autres termes la méthode d'acquisition comprimée NUWBS telle que décrite dans l'état de la technique suppose de recourir à des convertisseurs A/D rapides pour analyser ou acquérir des signaux large bande. Or, de tels convertisseurs sont coûteux et ne présentent pas une grande dynamique.

Le but de la présente invention est par conséquent de proposer une méthode d'acquisition comprimée permettant d'acquérir un signal/analyser une large bande RF et, le cas échéant de reconstruire le signal qui y est présent, sans devoir recourir à des convertisseurs A/D opérant à une cadence élevée, de l'ordre de la largeur de bande en question.

## Présentation de l'invention

La présente invention est définie par une méthode d'acquisition comprimée d'un signal spectralement parcimonieux au sein d'une bande spectrale donnée telle que définie par la revendication 1.

Les méthodes d'acquisition selon la présente divulgation sont applicables à des signaux numériques, mais surtout et de préférence à des signaux analogiques. Dans ce cas, dans certains modes de réalisation, le train d'impulsions est sous forme analogique et est mélangé au signal également sous forme analogique.

Dans certaines variantes de ces modes de réalisation, le résultat du mélange ensuite est filtré et échantillonné sous forme analogique, puis converti sous forme numérique par un convertisseur analogique numérique.

La fréquence de répétition est avantageusement modulée linéairement dans le temps.

Dans certains modes de réalisation, la fréquence de répétition parcourt pendant la trame d'acquisition une plage de fréquence de répétition entre une valeur minimale $PRF_{min}$ et une valeur maximale $PRF_{max}$, soit par valeurs croissantes, soit par valeurs décroissantes.

Dans certains modes de réalisation, l'excursion de modulation de la fréquence de répétition ($Bi_n$) est choisie de manière à ce que, pour au moins une raie spectrale d'ordre k du train d'impulsion (et de préférence pour une pluralité de ces raies), la largeur spectrale $B_{sweep}^{k}$ balayée par ladite au moins une raie spectrale d'ordre k est supérieure à la fréquence de répétition moyenne $\overline{PRF}$ des impulsions sur la durée de la trame d'acquisition.

Ainsi, selon différentes variantes, pour au moins une et de préférence pour une pluralité de sous-bandes générées par différentes harmoniques, il n'y a pas de recouvrement spectral de la ou des sous-bandes sur la durée de la rampe

Les impulsions sont typiquement choisies parmi des ondelettes de Morlet, des ondelettes de Haar et des fonctions de Gabor.

Le filtre passe-bande présente avantageusement une fréquence de coupure sensiblement égale à $\overline{PRF}/2$ où $\overline{PRF}$ est la fréquence de répétition moyenne des impulsions sur la durée de la trame d'acquisition.

Selon une variante, le signal reçu est mélangé pendant une trame d'acquisition avec un premier train d'impulsions se succédant à une première fréquence de répétition au sein de cette trame, et pendant cette même trame d'acquisition, est mélangé avec un second train d'impulsions se succédant avec une seconde fréquence de répétition, les première et seconde fréquences de répétition étant linéairement modulées dans le temps pendant la trame d'acquisition.

Le résultat du mélange avec le premier train d'impulsions est ensuite filtré au moyen d'un premier filtrage passe-bas avant d'être échantillonné pour fournir des premiers échantillons complexes, et le résultat du mélange avec le second train d'impulsions est filtré au moyen d'un second filtrage passe-bas avant d'être échantillonné pour fournir des seconds échantillons complexes, l'ensemble des premiers et seconds échantillons complexes étant représentatifs du signal reçu.

L'invention concerne en outre une méthode de reconstruction d'un signal spectralement parcimonieux au sein d'une bande spectrale donnée, ledit signal ayant fait l'objet d'une acquisition comprimée par une méthode d'acquisition comprimée comme indiqué ci-dessus, les échantillons complexes relatifs aux différentes impulsions du train d'impulsions étant successivement multipliés par des valeurs spectrales de ces impulsions pour fournir des valeurs spectrales pondérées, cette opération étant répétée pour une pluralité de fréquences équidistribuées dans la bande spectrale, lesdites valeurs spectrales pondérées étant sommées sur la durée de la trame d'acquisition pour chaque fréquence de la pluralité de fréquences équidistribuées pour obtenir des coefficients complexes à chacune de ces fréquences, des phaseurs à ces fréquences étant ensuite pondérés par lesdits coefficients correspondants avant d'être sommés pour fournir une estimation du signal reçu.

**Brève description des figures**

D'autres caractéristiques et avantages de l'invention apparaîtront à la lecture d'un mode de réalisation préférentiel de l'invention, fait en référence aux figures jointes parmi lesquelles :

[Fig. 1] représente de manière schématique un récepteur RF utilisant une méthode d'acquisition comprimée par échantillonnage NUWBS, connue de l'état de la technique ;

[Fig. 2] représente un exemple de train d'impulsions utilisé dans le récepteur RF de la Fig. 1 ;

[Fig. 3A], [Fig. 3B] et [Fig.3C] représentent des histogrammes de fréquence de répétition pour des exemples de trains d'impulsions présentant différents taux de compression ;

[Fig. 4] représente un spectre et un spectrogramme pour deux exemples de trains d'impulsions sans modulation de PRF ;

[Fig. 5] représente un spectre et un spectrogramme pour deux exemples de trains d'impulsions avec une première modulation et une seconde modulation de PRF ;

[Fig. 6] représente un spectre et un spectrogramme pour deux exemples de trains d'impulsions avec une première modulation et une seconde modulation de PRF, mises en œuvre dans une méthode acquisition comprimée selon un mode de réalisation de la présente invention ;

[Fig. 7] représente schématiquement un module de reconstruction d'un signal ayant fait l'objet d'une acquisition comprimée selon un mode de réalisation de la présente invention ;

[Fig. 8] représente de manière schématique un dispositif d'acquisition comprimée et de reconstruction d'un signal selon une première variante de réalisation de la présente invention ; et

[Fig. 9] représente de manière schématique un dispositif d'acquisition comprimée et de reconstruction d'un signal selon une seconde variante de réalisation de la présente invention.

**Description des modes de réalisation**

Nous considérerons dans la suite un dispositif mettant en œuvre une méthode d'acquisition comprimée par échantillonnage non uniforme, NUWBS, comme décrit dans la partie introductive. L'acquisition comprimée fait appel à un mélange du signal à acquérir avec des trains d'impulsions distribuées au sein d'une trame. Les impulsions pourront être des ondelettes de Morlet, des ondelettes de Haar ou des fonctions de Gabor, de manière connue en soi.

A la différence de l'état de la technique décrit dans la partie introductive, les impulsions ne sont pas situées en $\Sigma$ positions temporelles prédéterminées, données par la période de répétition $\frac{1}{PRF}$, décimées au moyen du taux de compression $M/\Sigma$ de manière à n'en retenir que M parmi $\Sigma$.

Selon une première idée à la base de l'invention, pendant une trame d'acquisition de durée $T_{acq}$, la fréquence de répétition est modulée autour d'une valeur moyenne, notée *PRF,* avec une rampe de fréquence linéaire de pente $2\alpha$.

Autrement dit, la fréquence de répétition des impulsions au sein d'une trame varie entre les valeurs :

[Math. 1]

$$f_{start} = \overline{PRF} - \alpha T_{acq} = \overline{PRF} - \frac{B_{in}}{2} \qquad (1\text{-}1)$$

[Math. 2]

$$f_{stop} = f_{start} + 2\alpha T_{acq} = \overline{PRF} + \alpha T_{acq} = \overline{PRF} + \frac{B_{in}}{2} \qquad (1\text{-}2)$$

où $B_{in} = 2\alpha T_{acq}$ est l'excursion de la PRF pendant la durée de la trame d'acquisition.

Les positions temporelles indiquant le début des impulsions au sein de la trame sont choisies préférentiellement de telle sorte que la variation de phase due à la modulation de la PRF soit un multiple entier de $2\pi$.

Par exemple, dans le présent mode de réalisation, ces positions temporelles sont données par les instants $t_k$ vérifiant :

[Math. 3]

$$2\pi(f_{start}t_k + \alpha t_k^2) = 2\pi k \quad ; \quad t_k \in \left[0, T_{acq}\right] \tag{2}$$

d'où :
[Math. 4]

$$t_k = \frac{f_{start}}{2\alpha}\left(-1 + \sqrt{1 + \frac{2\alpha}{f_{start}}(2k-1)}\right) \tag{3}$$

Autrement dit, les positions temporelles des impulsions sont celles pour lesquelles la variation de phase due à la modulation de la PRF est un multiple entier de $2\pi$. Lorsque la fréquence de répétition croit linéairement pendant la durée de la trame ($\alpha > 0$), les impulsions deviennent de plus en plus rapprochées. Inversement, lorsque la fréquence de répétition décroit linéairement pendant la durée de la trame ($\alpha < 0$), les impulsions deviennent de plus en plus espacées.

En définitive ; le train d'impulsions peut s'exprimer sous la forme :
[Math. 5]

$$p_c(t) = s_{pulse}(t) \otimes \sum_{k=1}^{N_{max}} \delta(t - t_k) = s_{pulse}(t) \otimes \left(\prod_{[0,T_{acq}]}(t) \cdot \sum_k \delta(t - t_k)\right) \tag{4}$$

où $\prod_{[0,T_{acq}]}(t)$ est la fonction porte sur [0 $T_{acq}$] et $\sum_k \delta(t - t_k)$ est un peigne de Dirac (non uniforme si $\alpha \neq 0$) .

Par exemple, si les impulsions sont des ondelettes de Morlet, le train d'impulsions peut alors s'écrire :
[Math. 6]

$$p_c(t) = \sum_{k=1}^{N_{max}} exp\left(-\frac{(t-t_k-\tau/2)^2}{2(\tau/6)^2}\right) \cdot exp(j2\pi f_c(t - t_k)) \tag{5}$$

où $\tau$ est la largeur de l'enveloppe gaussienne des impulsions.

De manière générale, le spectre du train d'impulsions s'exprime comme suit :
[Math. 7]

$$P_c(f) = S_{pulse}(f - f_c) \cdot \left(sinc\left(\frac{f}{T_{acq}^{-1}}\right) \otimes TF(\sum_k \delta(t - t_k))\right) \tag{6}$$

où $S_{pulse}(f)$ est le spectre de l'impulsion en bande de base, *sinc* est la fonction sinus cardinal, et *TF* est la transformée de Fourier.

En absence de modulation de PRF, autrement dit lorsque la fréquence de répétition est constante, le dernier terme de l'expression (6) n'est autre qu'un peigne uniforme de Dirac dans le domaine fréquentiel :
[Math. 8]

$$TF(\sum_k \delta(t - t_k)) = \sum_k \delta(f - k \cdot PRF) \tag{7}$$

dont l'écart entre raies est égal à la fréquence de répétition.

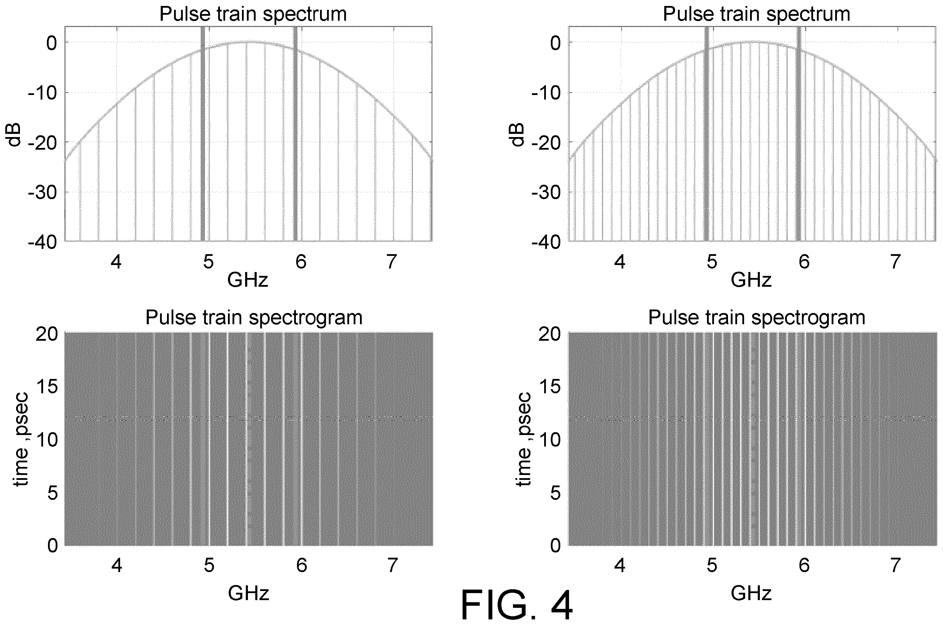

La Fig. 4 représente dans sa partie supérieure le spectre de deux trains d'impulsions pour une fréquence porteuse $f_c = 5.4 GHz$ et de fréquence de répétition constante. Le cas illustré à gauche correspond à une PRF de 200 MHz et celui de droite à une PRF de 100 MHz. La largeur de bande à analyser, $W_{RF}$, est dans les deux cas égale à 1 $GHz$. Dans la partie inférieure de la figure ont été représentés les spectrogrammes correspondant à ces deux cas. En absence de modulation de PRF, les raies spectrales sont fixes et aucun balayage n'intervient dans la bande à analyser.

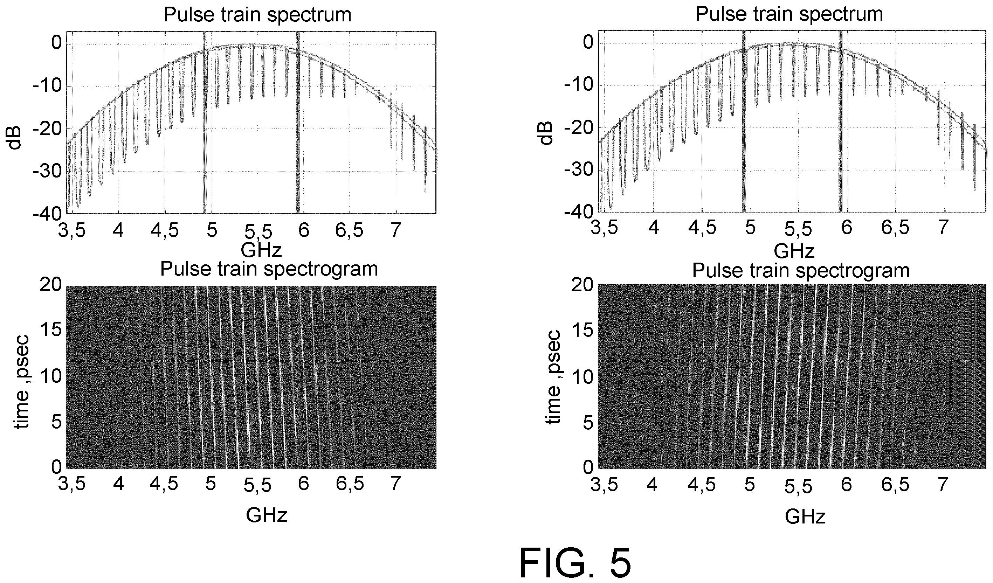

La Fig. 5 représente dans sa partie supérieure le spectre de deux trains d'impulsions pour une fréquence porteuse $f_c = 5.4 GHz$ mais de fréquence de répétition modulée autour de la valeur moyenne $PRF = 200 MHz$. L'excursion en fréquence sur la durée d'acquisition, $T_{acq}$, est de $B_{in} = 5 MHz$, la fréquence de répétition décroissant linéairement dans le cas illustré à gauche de la figure et croissant linéairement dans le cas illustré à droite.

En lieu et place d'un spectre de raies, on observe un spectre de sous-bandes.

Dans ce spectre, chaque harmonique d'ordre *k* de la fréquence de répétition $\overline{PRF}$ donne naissance à une sous-bande de largeur $B_{sweep}^k = (k_{mult} + k - 1) . B_{in}$ où $k_{mult}$ est l'entier défini par $k_{mult} = \left\lfloor \frac{f_c}{PRF} \right\rfloor$ . On remarquera sur la figure que les sous-bandes sont d'autant plus larges que l'ordre de l'harmonique est élevé. Par ailleurs, chacune des sous-bandes est résolue dans la mesure où $B_{sweep}^k < PRF_{min}$ où $PRF_{min}$ la valeur de PRF la plus faible observée sur la durée d'acquisition, $T_{acq}$. Autrement dit, $PRF_{min} = PRF_{start}$ pour une modulation par valeurs croissantes et $PRF_{min} = PRF_{stop}$ pour une modulation par valeurs décroissantes.

Dans la partie inférieure de la figure ont été représentés les spectrogrammes correspondant aux deux précités. Le spectrogramme de gauche correspond à une modulation de PRF par valeurs décroissantes et celui de droite à une modulation de PRF par valeurs croissantes. On peut voir que les raies correspondant aux différentes harmoniques se déplacent au cours du temps vers les basses fréquences dans le premier cas et vers les hautes fréquences dans le second cas. Etant donné que $B_{sweep}^k < PRF_{min}$ , les rampes de variation de raies adjacentes ne se recouvrent pas sur la durée d'acquisition.

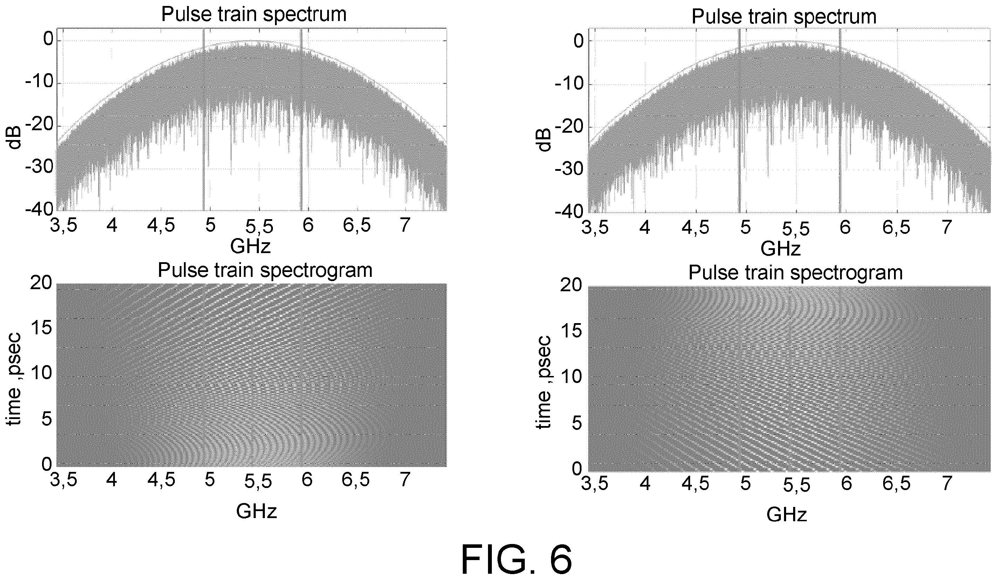

La Fig. 6 représente à nouveau dans sa partie supérieure le spectre de deux trains d'impulsions pour une fréquence porteuse $f_c = 5.4\,GHz$ de fréquence de répétition modulée autour de la valeur moyenne $PRF = 200\,MHz$. Comme dans la figure précédente, la fréquence de répétition décroit linéairement dans le cas illustré à gauche de la figure et croit linéairement dans le cas illustré à droite. L'excursion en fréquence de la PRF, $B_{in,}$ sur la durée de l'acquisition est ici choisie de manière à ce que $B_{sweep}^k > PRF_{min}$ , autrement dit les sous-bandes générées par les différentes harmoniques sont ici recouvrantes, au moins pour les harmoniques d'ordres élevés. Dans le cas illustré en Fig. 6, $B_{sweep}^k > PRF_{max}$ où $PRF_{max}$ la valeur de PRF la plus élevé observée sur la durée d'acquisition, $T_{acq}$. Autrement dit, $PRF_{max} = PRF_{stop}$ pour une modulation par valeurs croissantes et $PRF_{max} = PRF_{start}$ pour une modulation par valeurs décroissantes. On remarque que toutes les sous-bandes sont recouvrantes et par conséquent qu'aucune ne peut être résolue.

Les spectrogrammes correspondant aux deux cas précités sont représentés dans la partie inférieure de la figure. Du fait du recouvrement des sous-bandes, les spectrogrammes sont denses dans la bande RF d'acquisition.

Selon la présente invention, le fait de moduler de fréquence de répétition des impulsions sur la durée d'acquisition, $T_{acq}$, permet d'obtenir une distribution de probabilité moins piquée autour de la fréquence de répétition maximale, autrement dit de ne recourir que rarement voire jamais au pas d'échantillonnage le plus faible $(BW_{RF})^{-1}$. En conséquence, il est possible d'utiliser des convertisseurs opérant à une cadence ou fréquence moyenne $\overline{PRF}$ faible tout en permettant la reconstruction du signal comme décrit ci-après, ce qui permet de limiter la consommation d'énergie. Cette cadence moyenne $PRF$ vérifie autant que possible $PRF < 2\,BW_{RF,}$ et de préférence $PRF < BW_{RF}$.

De manière étonnante, cette propriété reste vraie lorsque les sous-bandes issues des différentes harmoniques sont recouvrantes.

La reconstruction du signal est réalisée à partir des échantillons complexes obtenus par la méthode d'acquisition compressée décrite plus haut. Ces échantillons sont le résultat d'un échantillonnage non uniforme, piloté par la fréquence de répétition modulée dans le temps. Il convient de noter que cet échantillonnage non uniforme ne vérifie pas le théorème de Nyquist et induit par conséquent des repliements de spectre dans le signal acquis. Une méthode de reconstruction spécifique est par conséquent nécessaire.

On peut considérer que chaque échantillon complexe, $s_n$, est le résultat de la convolution d'une seule impulsion du train d'impulsions pondérée par le signal d'entrée $s(t)$, avec la réponse impulsionnelle du filtre AGC :
[Math.9]

$$s_n = \delta(t - t_n^s) . \left( h_{agc}(t) \otimes p_n^*(t) . s(t) \right) \tag{8}$$

où $t_n^s$ est le nième instant d'échantillonnage, $h_{agc}(t)$ est la réponse impulsionnelle du filtre AGC, $p_n^*(t)$ est le conjugué complexe de la nième impulsion et $s(t)$ est le signal en sortie de l'amplificateur LNA, avant le mélange avec le train d'impulsions.

On suppose dans la suite que le filtre AGC présente une bande passante supérieure à la bande balayée par le train d'impulsions et que la réponse en phase du filtre est linéaire dans la bande ainsi balayée. Dans ce cas, le filtre peut être considéré comme une simple cellule à retard, de retard $\tau_d$ et de gain $\gamma_{agc}$ et :
[Math. 10]

$$s_n = \delta(t - t_n^s) . \gamma_{agc} . p_n^*(t - \tau_d) . s(t - \tau_d) \tag{9}$$

En choisissant $t_n^s = t_n + \tau_d$ et en effectuant un changement de référence temporelle, on obtient, en multipliant les deux membres de l'équation par $p_n(t)$ :
[Math.11]

$$s_n \cdot p_n(t) = \gamma_{agc} \cdot \delta(t - t_n) \cdot p_n^*(t) p_n(t) \cdot s(t) \qquad (10)$$

[Math.12]

$$TF(s_n \cdot p_n(t)) = s_n P_n(f) = \gamma_{agc} \cdot p_n^*(t_n) p_n(t_n) \cdot s(t_n) e^{-j2\pi f t_n} = \gamma \cdot s(t_n) e^{-j2\pi f t_n} \qquad (11)$$

étant donné que $p_n^*(t_n) p_n(t_n)$ est une constante réelle.

On peut alors reconstruire le signal au moyen de :
[Math. 13]

$$\hat{X}(f) = \frac{1}{\gamma} \sum_{n=1}^{N_{max}} s_n P_n(f) = \sum_{n=1}^{N_{max}} s(t_n) \cdot e^{-j2\pi f t_n} \qquad (12)$$

Le terme de droite n'est autre que la valeur du spectre prise à la fréquence *f* obtenue par interpolation des phaseurs $e^{-j2\pi f t_n}$ par les échantillons $s(t_n)$. Le signal *x(t)* peut alors être estimé par transformée de Fourier inverse $\hat{x}(t) = TF^{-1}(\hat{X}(f))$.

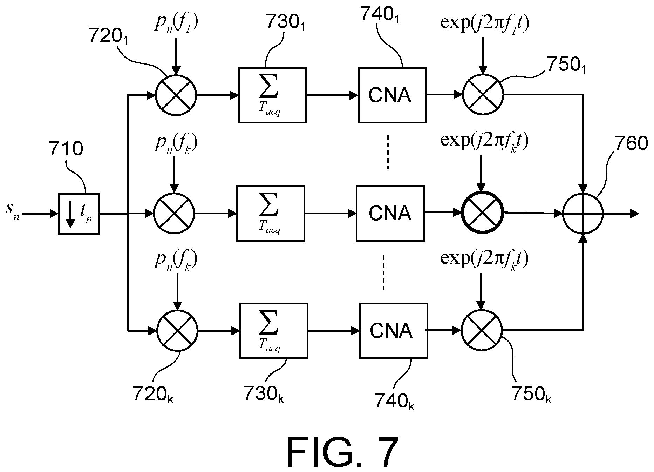

La Fig. 7 représente schématiquement un module de reconstruction d'un signal ayant fait l'objet d'une acquisition comprimée selon un mode de réalisation de la présente invention.

Le module de reconstruction reçoit les échantillons complexes $s_n$ à une cadence variable, aux instants $t_n$ (définis par l'expression (3)) les échantillons étant stockés dans un buffer FIFO 710. Les échantillons sont ensuite lus à cadence constante et multipliés respectivement par les valeurs spectrales $P_n(f_1),...,P_n(f_K)$ par les multiplieurs $720_1,...,720_K$ où $P_n(f)$ est la transformée de Fourier de la nième impulsion et $f_1,..., f_K$ sont des fréquences équidistribuées dans la bande d'intérêt à analyser, $BW_{RF}$. Les modules de sommation $730_1, ...,730_K$ somme les résultats obtenus sur la durée de la trame d'acquisition, autrement dit sur le train d'impulsions et les résultats de sommation pondérant les phaseurs $exp(j2\pi f_1 t), ..., exp(j2\pi f_K t)$ dans les multiplieurs $750_1,...,750_K$. Le cas échéant, la multiplication avec les phaseurs peut être réalisée dans le domaine analogique en effectuant préalablement une conversion des résultats de sommation au moyen des convertisseurs CNA optionnels, $750_1,...,750_K$, représentés en traits discontinus.

Dans tous les cas, les phaseurs ainsi pondérés sont ensuite sommés dans le sommateur 760 pour fournir une estimation du signal reçu, $\hat{x}(t)$.

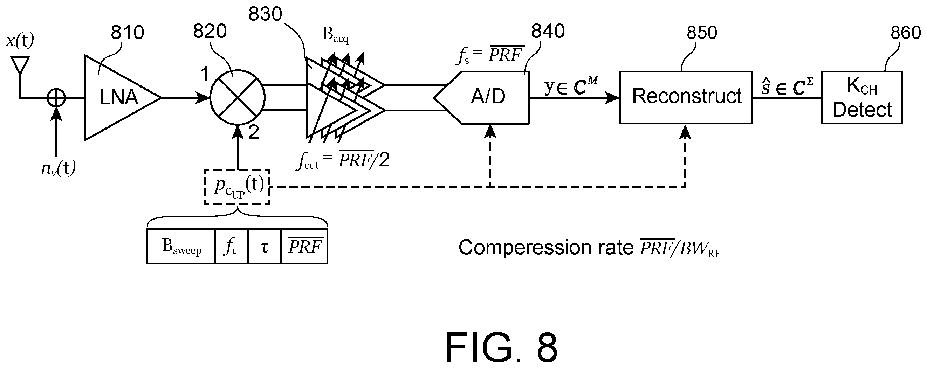

La Fig. 8 représente de manière schématique un dispositif d'acquisition comprimée et de reconstruction d'un signal selon une première variante de réalisation de la présente invention.

Le dispositif d'acquisition comprimée et de reconstruction comprend un amplificateur bas bruit, 810, un mélangeur complexe, 820 (voies I et Q) du signal amplifié avec un train d'impulsions à PRF modulée comme décrit plus haut, avec *PRF < BW$_{RF}$*, la modulation de PRF pouvant être effectuée par valeurs croissantes ou décroissantes. Le résultat du mélange est filtré par un filtre AGC, 830, de fréquence de coupure égale à $\overline{PRF}/2$ puis converti par un convertisseur analogique numérique (sur chacune des voies I et Q), 840. Les échantillons complexes issus de l'acquisition comprimée sont fournis à un module de reconstruction tel que précédemment décrit en relation avec la Fig. 7 pour obtenir une estimation du signal reçu. Dans certains cas, lorsque la bande $BW_{RF}$ est divisée en canaux, il peut être intéressant de scanner la bande en question pour déterminer dans quel canal un signal est émis. Dans l'hypothèse de K tels canaux, on peut alors se contenter d'effectuer une détection en sortie des sommateurs $730_1,...,730_K$ pour en déduire le(s) canal (canaux) utilisé(s), comme représenté par le module de détection 860. Lorsqu'un canal est déterminé comme utilisé, une acquisition compressive au moyen d'un train d'impulsions à PRF constante peut être effectuée en choisissant la PRF de manière à ne pas induire de repliement dans le canal en question.

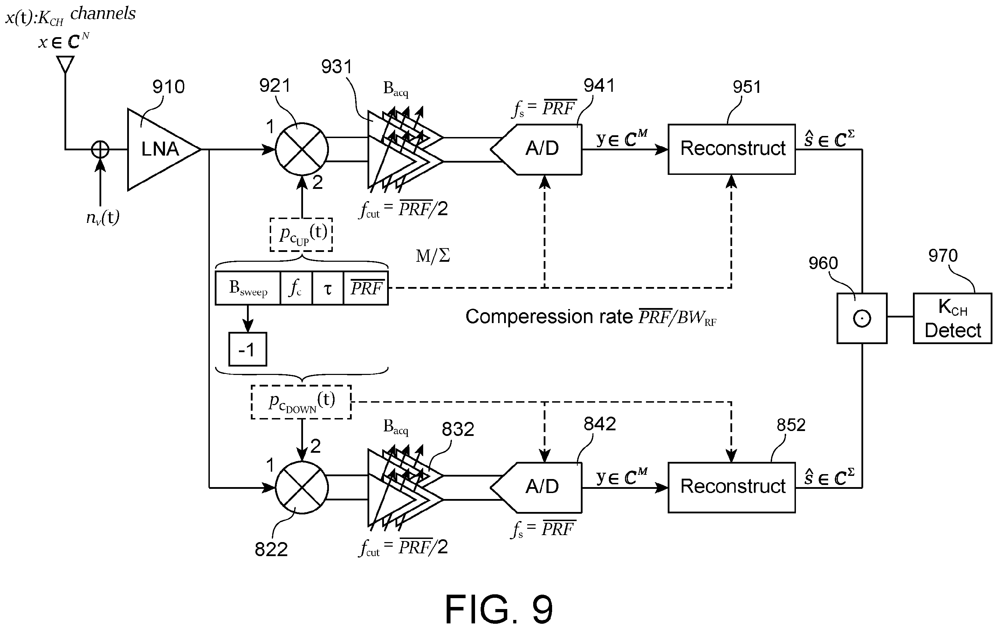

La Fig. 9 représente de manière schématique un dispositif d'acquisition comprimée et de reconstruction d'un signal selon une seconde variante de réalisation de la présente invention.

Cette seconde variante se distingue de la première en ce qu'après amplification dans l'amplificateur bas bruit, 910, le signal amplifié est soumis en parallèle à une première chaine d'acquisition comprimée 921-941, dans laquelle le signal amplifié est mélangé avec un premier train d'impulsions à PRF modulée par valeurs croissantes et à une seconde chaine d'acquisition comprimée 922-942, dans laquelle le signal amplifié est mélangé avec un second train d'impulsions à PRF modulée par valeurs décroissantes. Avantageusement, les première et seconde chaines d'acquisition compressée utiliseront la même durée de trame d'acquisition, $T_{acq}$, ainsi que la même impulsion, et donc une même fréquence porteuse $f_c$ et une même forme d'onde de durée $\tau$. En revanche, ces deux chaines d'acquisition compressée utilisent des rampes de modulation de pentes opposées, $2\alpha$ pour la première et $-2\alpha$ pour la seconde. Ainsi la PRF du premier train d'impulsions varie de $PRF_{min}$ à $PRF_{max}$ et le second train d'impulsions varie de $PRF_{max}$ à $PRF_{min}$ sur la durée de la trame d'acquisition. On comprend qu'ainsi les positions temporelles des impulsions dans les premier et second trains d'impulsions sont différentes, ce qui permet de réduire encore davantage la valeur moyenne de la fréquence de répétition, $\overline{PRF}$, commune aux deux branches, au prix certes d'une taille de circuit plus importante.

Les échantillons complexes issus de la première branche sont ensuite fournis à un premier module de reconstruction, 951, et ceux issus de la seconde branche à un second module de reconstruction, 952, chaque module utilisant le train d'impulsions utilisé dans la branche correspondante.

Dans cette seconde variante, les signaux issus des modules de reconstruction sont issus des sommateurs $730_1,...,730_K$ tels que représentés en Fig. 7, la sommation étant effectuée sur des intervalles de temps, dont la durée $T_{acq}/M$ est une fraction de la période d'acquisition $T_{acq}$.

Les signaux reconstruits par 951 et 952 sont multipliés, fréquence par fréquence, et pour chaque fréquence, $f_k$, les résultats de multiplication sont sommés sur les M intervalles, pour donner une estimation du signal aux fréquences $f_1,..., f_K$. On peut montrer que cette opération permet d'atténuer les raies parasites (résultant du repliement) dans le spectrogramme.

Comme dans la première variante, le dispositif de la Fig. 9 peut être utilisé pour scanner une bande $BW_{RF}$ divisée en canaux. Dans ce cas, une détection est réalisée après la sommation précitée sur les *M* intervalles. Là encore, lorsqu'un canal est déterminé comme utilisé, une acquisition comprimée au moyen d'un train d'impulsions à PRF constante pourra ensuite être réalisée. On comprend qu'alors la PRF pourra être la moitié de celle mise en œuvre dans la première variante, les positions temporelles des impulsions dans les deux trains d'impulsions étant décimées par un facteur 2, le premier train d'impulsions pouvant comprendre des impulsions aux positions temporelles de rangs impairs et le second des impulsions aux positions temporelles de rangs pairs.

## Revendications

**1.** Méthode d'acquisition comprimée d'un signal spectralement parcimonieux au sein d'une bande spectrale donnée, le signal reçu étant mélangé (820) pendant une trame d'acquisition avec un train d'impulsions se succédant à une fréquence de répétition au sein de cette trame, lesdites impulsions étant de durée inférieure ou égale à l'inverse de largeur de la bande spectrale et présentant un spectre centré sur la fréquence centrale de cette bande, le résultat du mélange étant filtré (830) au moyen d'un filtrage passe-bas avant d'être échantillonné (840) pour fournir des échantillons complexes représentatifs du signal reçu, ladite fréquence de répétition étant modulée dans le temps pendant la durée de la trame d'acquisition ; la méthode **se caractérisant en ce que** l'excursion de modulation de la fréquence de répétition, $B_{in}$, est choisie de manière à ce que la largeur spectrale balayée par chaque raie spectrale du train d'impulsion, $B_{sweep}^k = (k_{mult} + k - 1) \cdot B_{in}$ est telle que

$$B_{sweep}^k > PRF_{min} \quad \text{où } k_{mult} \text{ est l'entier défini par} \quad k_{mult} = \left\lfloor \frac{f_c}{\overline{PRF}} \right\rfloor \cdot f_c \text{ est ladite fréquence centrale,}$$

$$\overline{PRF}$$

est la fréquence de répétition moyenne des impulsions sur la durée de la trame d'acquisition et $PRF_{min}$ sa valeur minimale.

**2.** Méthode d'acquisition comprimée selon la revendication 1, **caractérisée en ce que** la fréquence de répétition est modulée linéairement dans le temps.

**3.** Méthode d'acquisition comprimée selon la revendication 1 ou 2, **caractérisée en ce que** la fréquence de répétition parcourt pendant la trame d'acquisition une plage de fréquences de répétition entre la valeur minimale $PRF_{min}$ et une valeur maximale $PRF_{max}$, soit par valeurs croissantes, soit par valeurs décroissantes.

**4.** Méthode d'acquisition comprimée selon l'une quelconque des revendications 1 à 3, **caractérisée en ce que**, pour au moins une raie spectrale d'ordre k du train d'impulsion et de préférence pour une pluralité de telles raies, l'excursion de modulation de la fréquence de répétition, $B_{in}$, est choisie de manière à ce que la largeur spectrale , $B^k_{sweep}$, balayée par ladite au moins une raie spectrale d'ordre k du train d'impulsions est supérieure à la fréquence de répétition moyenne

$$, \overline{PRF},$$

des impulsions sur la durée de la trame d'acquisition.

5. Méthode d'acquisition comprimée selon l'une des revendications précédentes, **caractérisée en ce que** les impulsions sont choisies parmi des ondelettes de Morlet, des ondelettes de Haar et des fonctions de Gabor.

6. Méthode d'acquisition comprimée selon l'une des revendications précédentes, **caractérisée en ce que** le filtre passe-bande présente une fréquence de coupure égale à $\overline{PRF}/2$ .

7. Méthode d'acquisition comprimée selon l'une quelconque des revendications 1 à 6, **caractérisée en ce qu'**aux positions temporelles indiquant le début des impulsions, la variation de phase due à la modulation de la fréquence de répétition est un multiple entier de $2\pi$.

8. Méthode d'acquisition comprimée selon l'une quelconque des revendications 1 à 7, **caractérisée en ce que** la cadence moyenne de répétitior

$$, \overline{PRF},$$

des impulsions sur la durée de la trame d'acquisition est inférieure au double de la largeur, $BW_{RF}$, de la bande spectrale, et de préférence est inférieure à la largeur, $BW_{RF}$, de la bande spectrale.

9. Méthode d'acquisition comprimée selon la revendication 1, **caractérisée en ce que** le signal reçu est mélangé (921) pendant une trame d'acquisition avec un premier train d'impulsions se succédant à une première fréquence de répétition au sein de cette trame, et pendant cette même trame d'acquisition, est mélangé (922) avec un second train d'impulsions se succédant avec une seconde fréquence de répétition, les première et seconde fréquences de répétition étant linéairement modulées dans le temps, le premier train d'impulsions et le second train d'impulsions présentant des rampes de modulation de pentes opposées.

10. Méthode d'acquisition comprimée selon la revendication 9, **caractérisée en ce que** le résultat du mélange avec le premier train d'impulsions est filtré au moyen d'un premier filtrage passe-bas (931) avant d'être échantillonné (941) pour fournir des premiers échantillons complexes, et que le résultat du mélange avec le second train d'impulsions est filtré au moyen d'un second filtrage passe-bas (932) avant d'être échantillonné (942) pour fournir des seconds échantillons complexes, l'ensemble des premiers et seconds échantillons complexes étant représentatifs du signal reçu.

11. Méthode de reconstruction d'un signal spectralement parcimonieux au sein d'une bande spectrale donnée, ledit signal ayant fait l'objet d'une acquisition comprimée par une méthode d'acquisition comprimée selon l'une des revendications précédentes 1 à 10, **caractérisée en ce que** les échantillons complexes relatifs aux différentes impulsions du train d'impulsions sont successivement multipliés ($720_1$,..,$720_K$) par des valeurs spectrales de ces impulsions pour fournir des valeurs spectrales pondérées, cette opération étant répétée pour une pluralité de fréquences équidistribuées dans la bande spectrale, lesdites valeurs spectrales pondérées étant sommées ($730_1$,..,$730_K$) sur la durée de la trame d'acquisition pour chaque fréquence de la pluralité de fréquences équidistribuées pour obtenir des coefficients complexes à chacune de ces fréquences, des phaseurs à ces fréquences étant ensuite pondérés par lesdits coefficients correspondants avant d'être sommés pour fournir une estimation du signal reçu.

**Patentansprüche**

1. Komprimiertes Erfassungsverfahren eines spektral sparsamen Signals innerhalb eines gegebenen Spektralbandes, wobei das empfangene Signal während eines Erfassungsrahmens mit einer Impulsfolge gemischt wird (820), die mit einer Wiederholungsfrequenz innerhalb dieses Rahmens aufeinanderfolgt, wobei die Impulse eine Dauer haben, die kleiner oder gleich dem Kehrwert der Breite des Spektralbandes ist, und ein Spektrum besitzen, das auf die Mittelfrequenz dieses Bandes zentriert ist, wobei das Ergebnis der Mischung mittels einer Tiefpassfilterung gefiltert wird (830), bevor es abgetastet wird (840), um komplexe Abtastwerte zu liefern, die für das empfangene Signal repräsentativ sind, wobei die Wiederholungsfrequenz während der Dauer des Erfassungsrahmens zeitlich moduliert wird; wobei das Verfahren **dadurch gekennzeichnet ist, dass** die Modulationsauslenkung der Wiederholungsfrequenz $B_{in}$ so gewählt ist, dass die von jeder Spektrallinie der Impulsfolge gescannte Spektralbreite

$$B_{sweep}^{k} = (k_{mult} + k - 1) \cdot B_{in} \text{ so ist, dass } B_{sweep}^{k} > PRF_{min} \text{ wobei } k_{mult} \text{ die durch } k_{mult} = \left\lfloor \frac{f_c}{PRF} \right\rfloor,$$

definierte Ganzzahl ist, $f_c$ die zentrale Frequenz ist, $PRF$ die durchschnittliche Wiederholungsfrequenz der Impulse über die Dauer des Erfassungsrahmens ist und $PRF_{min}$ ihr Mindestwert ist.

2. Komprimiertes Erfassungsverfahren nach Anspruch 1, **dadurch gekennzeichnet, dass** die Wiederholungsfrequenz linear zeitmoduliert ist.

3. Komprimiertes Erfassungsverfahren nach Anspruch 1 oder 2, **dadurch gekennzeichnet, dass** die Wiederholungsfrequenz während des Erfassungsrahmens einen Wiederholungsfrequenzbereich zwischen dem minimalen Wert $PRF_{min}$ und einem maximalen Wert $PRF_{max}$ durchläuft, entweder durch steigende Werte oder durch abnehmende Werte.

4. Komprimiertes Erfassungsverfahren nach einem der Ansprüche 1 bis 3, **dadurch gekennzeichnet, dass** für mindestens eine Spektrallinie der Ordnung k der Impulsfolge und vorzugsweise für eine Vielzahl solcher Linien die Modulationsabweichung der Wiederholungsfrequenz, $B_{in}$, so gewählt ist, dass die Spektralbreite, $B_{sweep}^{k}$, die von der mindestens einen Spektrallinie der Ordnung k der Impulsfolge gescannt wird, größer ist als die mittlere Wiederholungsfrequenz, $PRF$, der Impulse über die Dauer des Erfassungsrahmens.

5. Komprimiertes Erfassungsverfahren nach einem der vorhergehenden Ansprüche, **dadurch gekennzeichnet, dass** die Impulse aus Morlet-Wellen, Haar-Wellen und Gabor-Funktionen ausgewählt sind.

6. Komprimiertes Erfassungsverfahren nach einem der vorhergehenden Ansprüche, **dadurch gekennzeichnet, dass** der Bandpassfilter eine Abschaltfrequenz gleich $PRF/2$ besitzt.

7. Komprimiertes Erfassungsverfahren nach einem der Ansprüche 1 bis 6, **dadurch gekennzeichnet, dass** an den zeitlichen Positionen, die den Beginn der Impulse anzeigen, die Phasenänderung aufgrund der Modulation der Wiederholungsfrequenz ein ganzzahliges Vielfaches von $2\pi$ ist.

8. Komprimiertes Erfassungsverfahren nach einem der Ansprüche 1 bis 7, **dadurch gekennzeichnet, dass** die durchschnittliche Wiederholungsrate, $PRF$, der Impulse über die Dauer des Erfassungsrahmens weniger als das Doppelte der Breite, $BW_{RF}$, des Spektralbandes beträgt, und vorzugsweise kleiner als die Breite, $BW_{RF}$, des Spektralbandes ist.

9. Komprimiertes Erfassungsverfahren nach Anspruch 1, **dadurch gekennzeichnet, dass** das empfangene Signal während eines Erfassungsrahmens (921) mit einer ersten Impulsfolge gemischt wird, die innerhalb dieses Rahmens auf eine erste Wiederholungsfrequenz folgt, und während desselben Erfassungsrahmens mit einer zweiten Impulsfolge gemischt wird (922), die mit einer zweiten Wiederholungsfrequenz aufeinander folgt, wobei die erste und zweite Wiederholungsfrequenz linear zeitmoduliert sind, wobei die erste Impulsfolge und die zweite Impulsfolge gegenüberliegende Steilheitsmodulationsrampen besitzen.

10. Komprimiertes Erfassungsverfahren nach Anspruch 9, **dadurch gekennzeichnet, dass** das Ergebnis des Mischens mit der ersten Impulsfolge mittels einer ersten Tiefpassfilterung (931) gefiltert wird, bevor es zur Bereitstellung von ersten komplexen Abtastwerten (941) abgetastet wird, und dass das Ergebnis des Mischens mit der zweiten Impulsfolge mittels einer zweiten Tiefpassfilterung (932) gefiltert wird, bevor es zur Bereitstellung von zweiten komplexen Abtastwerten abgetastet (942) wird, wobei alle ersten und zweiten komplexen Abtastwerte repräsentativ für das empfangene Signal sind.

11. Verfahren zur Rekonstruktion eines spektral sparsamen Signals innerhalb eines bestimmten Spektralbandes, wobei das Signal durch ein komprimiertes Erfassungsverfahren nach einem der vorhergehenden Ansprüche 1 bis 10 erfasst wurde, **dadurch gekennzeichnet, dass** die komplexen Abtastwerte in Bezug auf die verschiedenen Impulse der Impulsfolge nacheinander durch spektrale Werte dieser Impulse multipliziert werden ($720_1$,..,$720_K$), um gewichtete spektrale Werte zu liefern, wobei dieser Vorgang für eine Vielzahl von gleichverteilten Frequenzen in dem Spektralband wiederholt wird, wobei die gewichteten spektralen Werte ($730_1$,..,$730_K$) über die Dauer des Erfassungsrahmens für jede Frequenz der Vielzahl von gleichverteilten Frequenzen addiert werden, um komplexe Koeffizienten für jede dieser Frequenzen zu erhalten, wobei Phaser bei diesen Frequenzen dann durch die entsprechenden Koeffizienten gewichtet werden, bevor sie addiert werden, um eine Schätzung des empfangenen Signals zu liefern.

**Claims**

1. Method for the compressed acquisition of a spectrally sparse signal within a given spectral band, the received signal being mixed (820) during an acquisition frame with a pulse train following a repetition frequency within this frame, said pulses being of duration less than or equal to the inverse of the width of the spectral band and having a spectrum centred on the centre frequency of this band, the result of the mixing being filtered (830) by means of low-pass filtering before being sampled (840) to provide complex samples representative of the received signal, said repetition frequency being modulated over time during the duration of the acquisition frame; the method being **characterised in that** the modulation excursion of the repetition frequency, $B_{in}$, is selected such that the spectral width swept by each spectral line of the pulse train, $B_{sweep}^k = (k_{mult} + k - 1) . B_{in}$ is such that $B_{sweep}^k > PRF_{min}$ where $k_{mult}$ is the integer defined by $k_{mult} = \left\lfloor \frac{f_c}{PRF} \right\rfloor$, $f_c$ is said centre frequency, $PRF$ is the average repetition frequency of the pulses over the duration of the acquisition frame and $PRF_{min}$ its minimum value.

2. Compressed acquisition method according to claim 1, **characterised in that** the repetition frequency is linearly modulated over time.

3. Compressed acquisition method according to claim 1 or 2, **characterised in that** the repetition frequency covers during the sensing frame a range of repetition frequencies between the minimum value $PRF_{min}$ and a maximum value $PRF_{max}$, either by increasing values, or by decreasing values.

4. Compressed acquisition method according to any one of claims 1 to 3, **characterised in that**, for at least one k-order spectral line of the pulse train and preferably for a plurality of such lines, the modulation excursion of the repetition frequency $B_{in}$ is selected so that the spectral width, $B_{sweep}^k$, swept by said at least one k-order spectral line of the pulse train is greater than the mean repetition frequency, $PRF$, of the pulses over the duration of the acquisition frame.

5. The compressed sensing method according to one of the preceding claims, **characterised in that** the pulses are selected from Morlet wavelets, Haar wavelets and Gabor functions.

6. Compressed acquisition method according to one of the preceding claims, **characterised in that** the bandpass filter has a cut-off frequency equal to $\overline{PRF}/2$.

7. Compressed acquisition method according to any one of claims 1 to 6, **characterised in that**, at the time positions indicating the start of the pulses, the phase variation due to the modulation of the repetition frequency is an integer multiple of $2\pi$.

8. Compressed acquisition method according to any one of claims 1 to 7, **characterised in that** the mean repetition rate, $PRF$, of the pulses over the duration of the acquisition frame is less than twice the width, $BW_{RF}$, of the spectral band, and preferably is less than the width, $BW_{RF}$, of the spectral band.

9. Compressed acquisition method according to claim 1, **characterised in that** the received signal is mixed (921) during an acquisition frame with a first pulse train following at a first repetition frequency within this frame, and, during this same acquisition frame, is mixed (922) with a second pulse train following with a second repetition frequency, the first and second repetition frequencies being linearly modulated over time, the first pulse train and the second pulse train having modulation ramps with opposite slopes.

10. Compressed acquisition method according to claim 9, **characterised in that** the result of mixing with the first pulse train is filtered by means of a first low-pass filtering (931) before being sampled (941) to provide first complex samples, and **in that** the result of mixing with the second pulse train is filtered by means of a second low-pass filtering (932) before being sampled (942) to provide second complex samples, all of the first and second complex samples being representative of the received signal.

11. Method of reconstructing a spectrally sparse signal within a given spectral band, said signal having undergone a compressed acquisition by a compressed acquisition method according to one of the preceding claims 1 to 10, **characterised in that** the complex samples relating to the various pulses of the pulse train are successively multiplied ($720_1$,..,$720_K$) by spectral values of these pulses to provide weighted spectral values, this operation being repeated for a plurality of frequencies equidistributed over the spectral band, said weighted spectral values being added ($730_1$,..,$730_K$) over the duration of the acquisition frame for each frequency of the plurality of equidistributed frequencies to obtain complex coefficients at each of these frequencies, phasors at these frequencies being then weighted by said corresponding coefficients before being added to provide an estimate of the received signal.

FIG. 1

FIG. 2

FIG. 3A

**FIG. 3C**

Comperession rate $M/\Sigma = 0{,}9$

Probability density

PRF

$\times 10^8$

**FIG. 3B**

Comperession rate $M/\Sigma = 0{,}5$

Probability density

PRF

$\times 10^8$

FIG. 4

FIG. 5

EP 4 207 605 B1

FIG. 6

FIG. 7

FIG. 8

FIG. 9

EP 4 207 605 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3319236 A

- EP 3681040 A1

**Littérature non-brevet citée dans la description**

- **M. PELISSIER et al.** Non-uniform wavelet sampling for RF analog-to-information conversion. *IEEE Trans. On Circuits and Systems*, 2018, vol. 65 (2), 471-484